# EUROPÄISCHE PATENTANMELDUNG

(11) **EP 2 549 846 A1**
(43) Veröffentlichungstag der Anmeldung: **23.01.2013**
(21) Anmeldenummer: 11175039.4
(22) Anmeldetag: 22.07.2011
(51) Int. Cl.: H05K 7/20

(54) **Temperieren der Antriebskomponenten eines Fahrzeugs**

(71) Anmelder: Siemens Aktiengesellschaft, 80333 München (DE)
(72) Erfinder: Bittner, Roland, 91522 Ansbach (DE); Hösle, Markus, 91058 Erlangen (DE)

(57) **Zusammenfassung**

Zur Steigerung der Leistung eines Antriebs soll ein entsprechendes Betriebsverfahren für ein Elektrofahrzeug angegeben werden. Daher wird hier ein Verfahren zum Betreiben eines elektrisch angetriebenen Fahrzeugs, das mehrere Antriebskomponenten aufweist, vorgeschlagen, bei dem jede der Antriebskomponenten in Abhängigkeit von den jeweils anderen der Antriebskomponenten aktiv temperiert werden. Darüber hinaus wird ein entsprechendes Fahrzeug vorgeschlagen.

## Beschreibung

Die vorliegende Erfindung betrifft ein Verfahren zum Betreiben eines elektrisch angetriebenen Fahrzeugs, das mehrere Antriebskomponenten aufweist. Darüber hinaus betrifft die vorliegende Erfindung ein entsprechendes Fahrzeug mit einem elektrischen Antrieb, wobei der Antrieb mehrere Antriebskomponenten aufweist.

Die Erfindung lässt sich insbesondere für Kraftfahrzeuge anwenden, die rein elektrisch betrieben werden, aber auch für Fahrzeuge, die einen Hybridantrieb einschließlich Verbrennungsmotor und Elektromotor aufweisen. Dies gilt grundsätzlich unabhängig davon, ob als Energiequelle eine Hochvoltbatterie oder eine Niedervoltbatterie eingesetzt wird.

Aus der Druckschrift DE 60 2004 012 949 T2 ist eine Kühleinrichtung für eine elektrische Hochspannungseinheit für Kraftfahrzeuge und Hybridfahrzeuge bekannt. Darin ist der übliche Umstand erwähnt, dass eine Batterie und ein Wechselrichter bei Betrieb Wärme abgeben. Die Ladungs- und Entladungsleistung einer Batterie kann sich aufgrund hoher Temperatur verschlechtern. Auch der Wechselrichter weist eine zulässige Höchsttemperatur auf, und er kann beschädigt werden, wenn die Temperatur die zulässige Höchsttemperatur überschreitet. Daher wird eine entsprechende Kühlvorrichtung für die elektrische Hochspannungseinheit für den Motor des Fahrzeugs vorgesehen, welche ein Gebläse zum Fördern von Kühlluft aufweist. Des Weiteren sind geeignete Wärmeableiter vorgesehen.

Darüber hinaus beschreibt die Druckschrift

DE 20 2005 009 886 U1 ein Heizgerät für elektrische Speichervorrichtungen für Fahrzeuge. Es ist nämlich bekannt, dass gängige Elektro- und Hybridfahrzeuge in der Regel effektiv in gemäßigten und warmen Klimazonen betrieben werden können, weniger effektiv jedoch in extrem kalten Klimazonen. Der Grund hierfür besteht darin, dass Hochspannungsantriebsbatterien dazu neigen, bei einem Abfall der Temperatur der Batteriezellen (z.B. unter etwa 20°C) Energie zu verlieren. Dieser Energieverlust führt zu einer verminderten Fahrzeugleistung, erhöhtem Kraftstoffverbrauch und ungünstigerem Fahrverhalten.

Zudem hängt die Leistung, die von einer Batterie abgegeben werden kann, nicht nur von Umwelteinflüssen, wie der Temperatur, ab, sondern auch von der Historie, wie und wie oft die Batterie geladen und entladen wurde. Außerdem ist bekannt, dass die Kapazität einer Batterie allein durch das Alter der Batterie abnimmt.

Grundsätzlich ist es wünschenswert, ein Fahrzeug möglichst wirtschaftlich zu betreiben. In gewissen Fahrsituationen kann es aber auch notwendig sein, dass der elektrische Antrieb des Fahrzeugs möglichst viel Leistung bereitstellt. Dazu ist eine entsprechende Optimierung des gesamten Antriebsstrangs notwendig.

Die Aufgabe der vorliegenden Erfindung besteht somit darin, die Leistung eines elektrischen Antriebsstrangs eines Fahrzeugs zu optimieren und hierfür ein entsprechendes Verfahren und ein geeignetes Fahrzeug bereitzustellen.

Erfindungsgemäß wird diese Aufgabe gelöst durch ein Verfahren zum Betreiben eines elektrisch angetriebenen Fahrzeugs, das mehrere Antriebskomponenten aufweist, durch aktives Temperieren jeder der Antriebskomponenten in Abhängigkeit von den jeweils anderen der Antriebskomponenten.

Darüber hinaus wird erfindungsgemäß bereitgestellt ein Fahrzeug mit einem elektrischen Antrieb, wobei der Antrieb mehrere Antriebskomponenten aufweist, sowie mit einer Temperierungseinrichtung zum aktiven Temperieren jeder der Antriebskomponenten in Abhängigkeit von den jeweils anderen der Antriebskomponenten.

In vorteilhafter Weise werden somit die Antriebskomponenten eines elektrisch betriebenen Fahrzeugs aktiv in Abhängigkeit voneinander temperiert. Dies hat den Vorteil, dass das Temperieren der einzelnen Antriebskomponenten aufeinander abgestimmt wird, sodass die insgesamt für das Temperieren des Antriebs notwendige Energie reduziert und dabei gleichzeitig eine optimale Leistungsfähigkeit des Antriebs erzielt werden kann.

Vorzugsweise umfasst das Temperieren ein Kühlen der jeweiligen Antriebskomponente. Damit kann die Verlustleistung des Antriebs zielgerichtet abgeführt werden, sodass eine der Antriebskomponenten oder auch alle Antriebskomponenten bei erhöhter Leistung betrieben werden können.

Insbesondere kann das Fahrzeug die Antriebskomponenten Batterie, Umrichter und Motor aufweisen. Diese Antriebskomponenten sind insbesondere bei leistungsfähigen Elektroantrieben von Vorteil.

Des Weiteren ist es vorteilhaft, wenn die mehreren Antriebskomponenten von einer einzigen Kühlvorrichtung gekühlt werden. Dadurch muss nicht jede einzelne Antriebskomponente mit einem separaten Kühlsystem ausgestattet werden.

Des Weiteren ist es günstig, wenn die Kühlvorrichtung einen Kühlmittelstrom erzeugt, der die mehreren Antriebskomponenten in Reihe durchströmt. Auf diese Weise lässt sich ein sehr einfaches Kühlsystem aufbauen. Es ist dann lediglich zu beachten, welche der Antriebskomponenten in der Reihe zuerst mit dem Kühlmittelstrom beaufschlagt wird. Dies lässt sich aber bei geeigneter Auslegung des Kühlsystems entsprechend steuern.

Gemäß einer Weiterbildung ist die Abhängigkeit von den Antriebskomponenten beim Temperieren eine zeitliche Reihenfolge der Antriebskomponenten beim Temperieren. Dies bedeutet, dass die einzelnen Antriebskomponenten in einer definierten zeitlichen Reihenfolge temperiert werden. So wird beispielsweise die Kühlung des Umrichters vor der Kühlung der Batterie und des Motors begonnen.

In einer weiteren Ausprägung wird in dem Fahrzeug ein Signal bereitgestellt, das eine spezifische Fahrsituation repräsentiert, und das Temperieren der Antriebskomponenten erfolgt dann auch in Abhängigkeit von dem Signal. Dies bedeutet, dass das Temperieren in Quantität und/oder Qualität als Funktion der Fahrsituation erfolgen kann.

Insbesondere ist es vorteilhaft, wenn die Fahrsituation ein Überholvorgang ist und das Temperieren einer der Antriebskomponenten dann sehr effizient beispielsweise mit Pressluft erfolgt. Damit kann kurzfristig eine hohe Kühlleistung erzielt werden, um einen Antrieb mit erhöhter Leistung kurzfristig zu erreichen.

Außerdem kann es vorteilhaft sein, für das Temperieren der Antriebskomponenten eine Überlastfähigkeit mindestens einer der Antriebskomponenten explizit zu berücksichtigen. Damit kann gegebenenfalls eine höhere Antriebsleistung kurzzeitig erzielt werden, wobei es nicht notwendig ist, die jeweilige Antriebskomponente auf die notwendige Nenntemperatur zu bringen.

Die vorliegende Erfindung wird nun anhand der beigefügten Zeichnungen näher erläutert, in denen zeigen:
- FIG 1: eine Prinzipskizze eines Fahrzeugs mit mehreren Antriebskomponenten und einem Kühlsystem; und
- FIG 2: den zeitlichen Verlauf von Kühlleistungen für einzelne Antriebskomponenten.

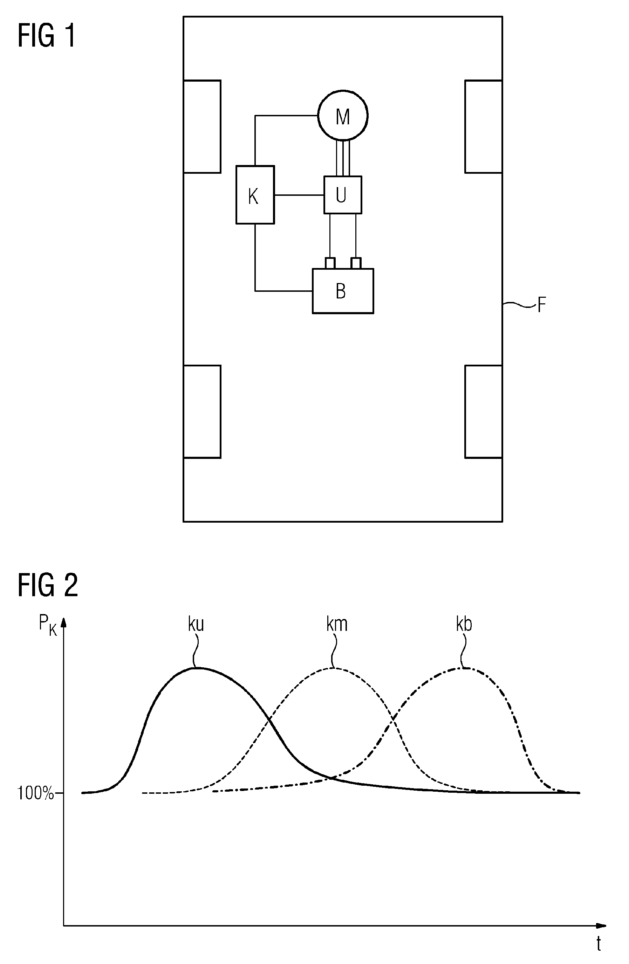

Die nachfolgend näher geschilderten Ausführungsbeispiele stellen bevorzugte Ausführungsformen der vorliegenden Erfindung dar. FIG 1 zeigt schematisch ein elektrisch angetriebenes Fahrzeug F. Der Antrieb des Fahrzeugs F besteht hier aus mehreren Antriebskomponenten, nämlich einer Batterie B, einem Umrichter U und einem Motor M. Die Anzahl der Antriebskomponenten kann aber auch variieren. Beispielsweise wird beim Einsatz eines Gleichstrommotors kein Umrichter U benötigt. Andererseits können aber auch mehrere Batterien oder beispielsweise zusätzliche Energiespeicher, wie Kondensatoren, vorgesehen sein. Entsprechend erhöht sich dann die Anzahl der Antriebskomponenten des Antriebs.

Es ist bekannt, dass die Leistung eines Elektromotors insbesondere durch zu hohe Temperaturen beschränkt ist. Ebenso hängt auch die Leistung einer Batterie von ihrer Temperatur ab. Diese Abhängigkeit variiert von Batterietyp zu Batterietyp. Bei niedrigen Temperaturen kann zur Leistungssteigerung auch ein Beheizen der Batterie notwendig sein.

In dem Beispiel von FIG 1 werden die einzelnen Antriebskomponenten M, U, B daher von einem Kühlsystem K gekühlt. Im allgemeinen Fall ist das Kühlsystem K als Klimatisierungssystem ausgebildet, sodass es auch in der Lage ist, eine oder mehrere der Antriebskomponenten M, U, B zu heizen.

In dem Beispiel von FIG 1 werden zu den einzelnen Antriebskomponenten M, U, B jeweils separate Kühlmittelströme geleitet. Entsprechend einer alternativen Ausführungsform kann von der Kühlvorrichtung bzw. dem Kühlsystem K auch ein einziger Kühlmittelstrom erzeugt werden, der in Reihe durch die einzelnen Antriebskomponenten bzw. an ihnen vorbei geschickt wird. Gegebenenfalls lässt sich die Reihenfolge der Kühlmittelbestromung durch entsprechende Ventile in geeigneter Weise steuern. In diesem Falle der bezüglich des Kühlmittelstroms in Reihe geschalteten Antriebskomponenten hängt das aktive Temperieren der einzelnen Antriebskomponenten jeweils davon ab, ob die Antriebskomponente beispielsweise die erste oder die letzte oder eine dazwischenliegende Komponente in dem Kühlmittelstrom ist. In Abhängigkeit davon hat sich der Kühlmittelstrom beim Erreichen einer Antriebskomponente bereits vorgewärmt, sodass die Kühlleistung entsprechend geringer ist. Bei der ersten Antriebskomponente in dem Kühlmittelstrom ist die Kühlleistung noch am höchsten.

Die einzelnen Antriebskomponenten M, U, B können von dem Kühlsystem K auch in einer bestimmten zeitlichen Reihenfolge gekühlt bzw. temperiert werden. Es bleibt dann beispielsweise die gesamte Kühlleistung des Kühlsystems K konstant und der Kühlmittelstrom wird je nach zeitlicher Anforderung zuerst zu der einen, dann zur nächsten Antriebskomponente und so weiter geführt.

Ein Beispiel für eine zeitliche Kühlreihenfolge ist in FIG 2 wiedergegeben. FIG 2 zeigt die Kühlleistung P_{K} über der Zeit. Es sind hier drei Leistungskurven ku, km, kb angegeben, die zeigen, dass eine maximale Kühlleistung zeitversetzt für unterschiedliche Antriebskomponenten aufgebracht werden. In dem vorliegenden Beispiel wird eine maximale Kühlleistung gemäß Kurve ku zunächst für den Umrichter U aufgewandt. Die Kühlleistung P_{K} beginnt hier bei 100%, was eine Nennkühlleistung andeutet. Der Umrichter U wird also kurzfristig mit einer höheren als der Nennkühlleistung gekühlt. Dementsprechend steigt die Kühlleistung P_{K} auf ein Maximum an und fällt wieder auf 100% zurück. Anschließend wird der Motor M im vorliegenden Beispiel mit der Kühlleistung gemäß der Kurve km gekühlt. Das Maximum dieser Kurve km liegt zeitlich später als das Maximum der Kurve ku. Der Motor wird also später mit maximaler Kühlleistung gekühlt als der Umrichter. Die Batterie B wird im vorliegenden Beispiel als letzte mit der maximalen Kühlleistung gekühlt. Dies zeigt die Kurve kb, deren Maximum zeitlich nach den Maxima der Kurven ku und km liegt.

Die Zeichnung in FIG 2 stellt nur ein Beispiel dar. Generell soll damit gezeigt werden, dass die zeitliche Kühlreihenfolge einzelner Antriebskomponenten separat festgelegt und gesteuert werden kann. Auch der zeitliche Verlauf der einzelnen Kühlleistungskurven ku, km und kb kann anders gestaltet sein. Insbesondere kann eine derartige Kurve auch bei einer geringeren Kühlleistung P_{K} beginnen als bei 100% (Nennleistung). In dem Beispiel von FIG 1 ist für die drei Antriebskomponenten M, U, B ein einziges Kühlaggregat vorgesehen. Die Temperierungseinrichtung kann aber auch mehrere Kühlaggregate (beispielsweise für jede Antriebskomponente ein Kühlaggregat) oder mehrere Heizaggregate aufweisen. In diesem Fall werden die einzelnen Aggregate der Temperierungseinrichtung durch eine Steuereinrichtung entsprechend zeitlich gesteuert. Dabei wird die Temperatur der anderen Antriebskomponenten oder der Energieaufwand bzw. der Betriebszustand der jeweils anderen Antriebskomponenten für die zeitliche Steuerung mit berücksichtigt.

In dem Beispiel von FIG 1 sind die Komponenten Batterie B, Motor M und Umrichter U einzeln oder gemeinsam zur Kühlung vorgesehen. Es können aber auch andere Antriebskomponenten wie zusätzliche Energiespeicher, Hochsetzsteller und dergleichen als Antriebskomponenten in der erfindungsgemäßen Weise temperiert werden.

Bei einer gemeinsamen Kühlung können bestimmte Kühlreihenfolgen Vorteile versprechen, da manche Komponenten besonders wärmeempfindlich sind und andere eine hohe Wärmezeitkonstante bzw. Wärmekapazität aufweisen. Beispielsweise ist es bei einer Kühlung in Reihe vorteilhaft, zuerst den Stromrichter und danach den Motor und anschließend eventuell die Batterie zu kühlen. Dies kann beispielsweise zu einer erhöhten Leistung für einen Überholvorgang dienen.

Als mögliche Kühlmethoden kommen beispielsweise die Luftkühlung, die Wasserkühlung, eine Pressluftkühlung (beispielsweise punktuell für Überholvorgang) und Heatpipes, deren Wärmesenke zur Fahrzeugheizung oder Batterieheizung benutzt wird, in Frage. Dies schließt natürlich auch andere Kühlsysteme wie Peltier-Elemente und dergleichen nicht aus.

Insbesondere im Winter kann es vorteilhaft sein, wenn die Verlustwärme des Stromrichters z.B. zunächst die Batterie erwärmt. Dies bedeutet, dass hier das Kühlen des Stromrichters in Abhängigkeit von der Temperatur der Batterie bzw. das Heizen der Batterie in Abhängigkeit von der Temperatur des Stromrichters erfolgt. Durch Wärmezufuhr wie auch durch Wärmeabfuhr (abhängig von der aktuellen Batterietemperatur) kann die Batteriekapazität optimiert werden.

Durch Wärmezufuhr kann außerdem ein Kondensieren von Wasser verhindert werden, was insbesondere im Winter von Bedeutung ist.

Bei einer Kühlung mit Pressluft kann die Luft in einem ohnehin bereits vorhandenen Tank der hierfür mit einem speziellen Ballon ausgestattet ist, in dem die Druckluft gegenüber dem restlichen Tank hermetisch abgeriegelt ist, (z.B. Ballon in einem Wasserstofftank eines Fahrzeugs mit Brennstoffzelle) gespeichert werden. Dabei kann die Druckluft zunächst komprimiert werden, wobei sie sich erwärmt. Mit Fahrtwind lässt sich die komprimierte Druckluft kühlen. Beim Entspannen der Druckluft kühlt sich die Luft deutlich ab, was zu einem starken Kühleffekt führen kann.

## Patentansprüche

1. Verfahren zum Betreiben eines elektrisch angetriebenen Fahrzeugs (F), das mehrere Antriebskomponenten (M,U,B) aufweist, **gekennzeichnet durch** aktives Temperieren jeder der Antriebskomponenten in Abhängigkeit von den jeweils anderen der Antriebskomponenten.

2. Verfahren nach Anspruch 1, wobei das Temperieren ein Kühlen der jeweiligen Antriebskomponente (M,U,B) umfasst.

3. Verfahren nach Anspruch 1 oder 2, wobei das Fahrzeug (F) die Antriebskomponenten Batterie (B), Umrichter (U) und Motor (M) aufweist.

4. Verfahren nach Anspruch 2, wobei die mehreren Antriebskomponenten (M,U,B) von einer einzigen Kühlvorrichtung (K) gekühlt werden.

5. Verfahren nach Anspruch 4, wobei die Kühlvorrichtung (K) einen Kühlmittelstrom erzeugt, der die mehreren Antriebskomponenten (M,U,B) in Reihe durchströmt.

6. Verfahren nach einem der vorhergehenden Ansprüche, wobei die Abhängigkeit von den Antriebskomponenten (M,U,B) beim Temperieren eine zeitliche Reihenfolge der Antriebskomponenten beim Temperieren ist.

7. Verfahren nach einem der vorhergehenden Ansprüche, wobei in dem Fahrzeug (F) ein Signal bereitgestellt wird, das eine spezifische Fahrsituation repräsentiert, und das Temperieren der Antriebskomponenten (M,U,B) auch in Abhängigkeit von dem Signal erfolgt.

8. Verfahren nach Anspruch 7, wobei die Fahrsituation ein Überholvorgang ist, und das Temperieren einer der Antriebskomponenten (M,U,B) gezielt mit Pressluft erfolgt.

9. Verfahren nach einem der vorhergehenden Ansprüche, wobei für das Temperieren der Antriebskomponenten (M,U,B) eine Überlastfähigkeit mindestens einer der Antriebskomponenten explizit berücksichtigt wird.

10. Fahrzeug mit
- einem elektrischen Antrieb, wobei
- der Antrieb mehrere Antriebskomponenten (M,U,B) aufweist, **gekennzeichnet durch**
- eine Temperierungseinrichtung zum aktiven Temperieren jeder der Antriebskomponenten in Abhängigkeit von den jeweils anderen der Antriebskomponenten.

## Geänderte Patentansprüche

### Geänderte Patentansprüche gemäss Regel 137(2) EPÜ.

**1.** Verfahren zum Betreiben eines elektrisch angetriebenen Fahrzeugs (F), das mehrere Antriebskomponenten (M,U,B) aufweist, durch aktives Temperieren jeder der Antriebskomponenten in Abhängigkeit von den jeweils anderen der Antriebskomponenten, **dadurch gekennzeichnet, dass** in dem Fahrzeug (F) ein Signal bereitgestellt wird, das eine spezifische Fahrsituation repräsentiert, und das Temperieren der Antriebskomponenten (M,U,B) auch in Abhängigkeit von dem Signal erfolgt.

**2.** Verfahren nach Anspruch 1, wobei das Temperieren ein Kühlen der jeweiligen Antriebskomponente (M,U,B) umfasst.

**3.** Verfahren nach Anspruch 1 oder 2, wobei das Fahrzeug (F) die Antriebskomponenten Batterie (B), Umrichter (U) und Motor (M) aufweist.

**4.** Verfahren nach Anspruch 2, wobei die mehreren Antriebskomponenten (M,U,B) von einer einzigen Kühlvorrichtung (K) gekühlt werden.

**5.** Verfahren nach Anspruch 4, wobei die Kühlvorrichtung (K) einen Kühlmittelstrom erzeugt, der die mehreren Antriebskomponenten (M,U,B) in Reihe durchströmt.

**6.** Verfahren nach einem der vorhergehenden Ansprüche, wobei die Abhängigkeit von den Antriebskomponenten (M,U,B) beim Temperieren eine zeitliche Reihenfolge der Antriebskomponenten beim Temperieren ist.

**7.** Verfahren nach einem der vorhergehenden Ansprüche, wobei die Fahrsituation ein Überholvorgang ist, und das Temperieren einer der Antriebskomponenten (M,U,B) gezielt mit Pressluft erfolgt.

**8.** Verfahren nach einem der vorhergehenden Ansprüche, wobei für das Temperieren der Antriebskomponenten (M,U,B) eine Überlastfähigkeit mindestens einer der Antriebskomponenten explizit berücksichtigt wird.

**9.** Fahrzeug mit
- einem elektrischen Antrieb, wobei
- der Antrieb mehrere Antriebskomponenten (M,U,B) aufweist,
und
- einer Temperierungseinrichtung zum aktiven Temperieren jeder der Antriebskomponenten in Abhängigkeit von den jeweils anderen der Antriebskomponenten,
**dadurch gekennzeichnet, dass**
- in dem Fahrzeug ein Signal bereitstellbar ist, das eine spezifische Fahrsituation repräsentiert, und das Temperieren der Antriebskomponenten (M,U,B) auch in Abhängigkeit von dem Signal erfolgt.
